# EUROPEAN PATENT APPLICATION

(11) **EP 4 455 784 A1**
(43) Date of publication of application: **30.10.2024**
(21) Application number: 23169554.5
(22) Date of filing: 24.04.2023
(51) Int. Cl.: G03F 7/00, B23K 26/04

(54) **IMAGE POSITIONING CONTROL METHOD AND SYSTEM**

(71) Applicant: ASML Netherlands B.V., 5500 AH Veldhoven (NL)
(72) Inventor: BUTLER, Hans, 5500 AH Veldhoven (NL)
(74) Representative: ASML Netherlands B.V.

(57) **Abstract**

A method of controlling an image positioning error in an optical system is described. The optical system comprises a first component, a second component and a third component arranged in an optical path of the optical system. The method comprises:
- determining an image positioning error of the first component and feeding through of the image positioning error of the first component to a control loop of the second component to at least partly compensate the image positioning error of the first component; and
- determining an image positioning error of the second component and feeding through of the image positioning error of the second component to a control loop of the third component to at least partly compensate the image positioning error of the second component.

## Description

### FIELD

The present invention relates to a method of controlling an image positioning error in an optical system comprising a first component, a second component and a third component arranged in an optical path of the optical system, an optical system comprising a first component, a second component and a third component arranged in an optical path of the optical system and a lithographic apparatus comprising the optical system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In optical systems, use may be made of plural optical elements, such as mirrors and/or an object holder, such as a substrate table to hold a substrate on which an optical pattern is to be projected. A position of the optical elements may be controlled in order to control an image positioning. An error in a position of one of the optical elements may result in an image positioning error, i.e. an error in the position of a pattern projected by the optical system. In an optical system of a lithographic apparatus, image positioning errors may result in overlay errors, which may limit a line width of the pattern projected on the substrate. Image positioning error may be due to an error in a positioning of a mirror, an error in a positioning of the patterning device which imparts a pattern on a projection beam and/or an error in a positioning of the substrate table, hence an error in a positioning of the substrate on which the pattern is to be projected.

It has been devised to at least partly compensate an image positioning error resulting from a position error of a mirror by feeding an error signal representative of the image positioning error resulting from the mirror to the substrate table. Using the feedforward of the error signal, the image positioning error may at least partly be compensated by a positioning of the substrate table.

### SUMMARY

An object of the present invention is to increase an accuracy of image positioning of an optical system, such as in a lithographic apparatus.

According to an aspect of the invention, there is provided a method of controlling an image positioning error in an optical system comprising a first component, a second component and a third component arranged in an optical path of the optical system, the method comprising:
- determining an image positioning error of the first component and feeding through of the image positioning error of the first component to a control loop of the second component to at least partly compensate the image positioning error of the first component;
- determining an image positioning error of the second component and feeding through of the image positioning error of the second component to a control loop of the third component to at least partly compensate the image positioning error of the second component.

According to another aspect of the invention, there is provided an optical system comprising a first component, a second component and a third component arranged in an optical path of the optical system and a controller to control the first component, the second component and the third component, wherein the controller is configured to:
- determine an image positioning error of the first component and feed through of the image positioning error of the first component to a control loop of the second component to at least partly compensate the image positioning error of the first component;
- determine an image positioning error of the second component and feed through of the image positioning error of the second component to a control loop of the third component to at least partly compensate the image positioning error of the second component.

According to yet another aspect of the invention, there is provided a lithographic apparatus comprising the optical system according to the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a highly schematic view of a control of an optical system illustrating feedthrough;
- Figure 3 depicts a highly schematic view of a control of another optical system illustrating feedthrough;

Figure 4 depicts a highly schematic view of a control of yet another optical system illustrating feedthrough; and
Figure 5A and 5B depicts detailed views of a part of an optical system as may be comprised in the optical system in accordance with Figure 4 .

### DETAILED DESCRIPTION

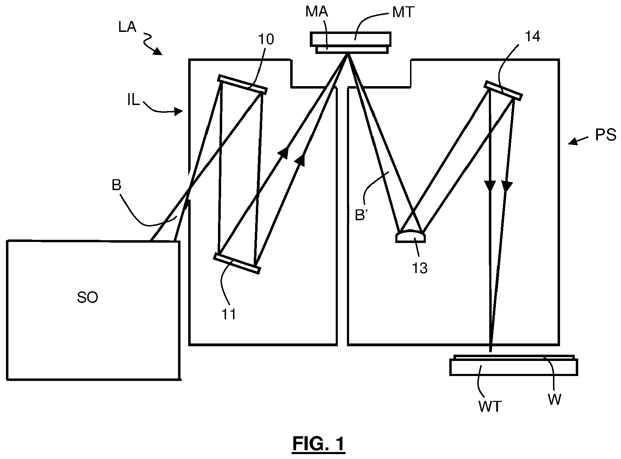

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

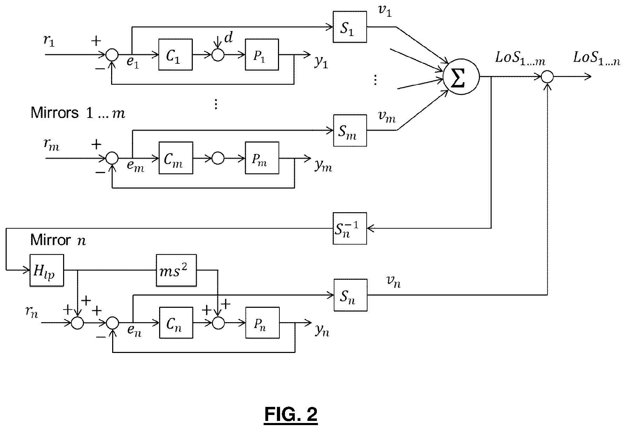

Figure 2 depicts a control diagram of an optical system, such as a protection system of a lithographic apparatus. The projection system comprises N mirrors. N may be an integer > 1. Each mirror may comprise an actuator to control a mirror position of the mirror, the mirror position may be controlled by a respective feedback controller. Referring to mirror 1, a setpoint of the position of the mirror is provided by r₁. Controller C₁ is comprised in a feedback control loop which controls a position of plant P₁ (the plant comprising the actuator which is configured to actuate the mirror, the mirror and a sensor which is configured to measure a position yi of the mirror. A sensor signal representative of the position of the mirror is compared to the position setpoint r₁ to generate an error signal e₁ which forms the input to the controller C₁ of the feedback loop. A position error, in the present embodiment indicated as a line of sight error LoS₁ is determine by a multiplication of the error signal e₁, which represents a difference between the mirror position setpoint and the measured mirror position, by the optical sensitivity S₁ of the first mirror S₁. The optical sensitivity may be understood as a quotient of image position error over mirror position error. The image position error may be understood as a difference between the actual position of the image projected by the optical system and the desired position of the image projected by the optical system. For example in the case of a lithographic apparatus configured to project a pattern of a substrate, the image position error may be understood as a difference between the position of the pattern on the substrate and the desired position of the pattern on the substrate. The optical system according to the present embodiment comprises n mirrors, whereby for each one of mirror 1 ...mirror m (m being n - 1), a respective position setpoint r, controller C, plant P, position y and error signal e is provided. Similarly as above, the error signals e of the respective control loops are multiplied by the respective optical sensitivities to form respective line of sight errors. The line of sight errors of the mirrors 1 - m are summed to form a summed Line of Sight error LoS_{1 ...m} for mirrors 1 - m.

The summed Line of Sight error of the mirrors 1 - m is fed through to a feedback control loop of mirror n, as follows: The summed Line of Sight error LoS_{1 .. m} is multiplied by an inverse of the optical sensitivity of mirror n S⁻¹ₙ, and fed through to mirror n as follows: The summed Line of Sight error LoS_{1 .. m} multiplied by the inverse of the optical sensitivity of mirror n S⁻¹ₙ is added to the setpoint rₙ of mirror n to form a reference for the nth mirror. Thereby the mirror n, i.e. the nth mirror is provided with an additional setpoint to compensate for the line of sight error by the mirrors 1 .. m. In an embodiment, the summed Line of Sight error LoS_{1 .. m} multiplied by an inverse of the optical sensitivity of mirror n S⁻¹ₙ is filtered, such as using a low pass filter Hₗₚₘ. Using the filter, a feed through of noise in the determined line of sight error of the mirrors 1 .. m, i.e. a feedthrough of such noise to mirror m, may be reduced. In an embodiment, in order to enhance a dynamic response of the image position error compensation, the summed Line of Sight error LoS_{1 .. m} multiplied by an inverse of the optical sensitivity of mirror n S⁻¹ₙ is provided as a feedforward signal to the plant n. Thereto, the summed Line of Sight error LoS_{1 .. m} multiplied by an inverse of the optical sensitivity of mirror n S⁻¹ₙ after having been filtered by the filter Hₗₚₘ is twice time differentiated and multiplied by a mass mₙ of the mirror n to generate a feedforward signal which is added to the output signal of the controller Cₙ of mirror n. Similarly to above, a line of sight error of the mirror n may be determined from the error signal eₙ of mirror n, or from the position yₙ and the combined reference inputs rₙ and feedthrough signal. Said signals may be multiplied by the optical sensitivity Sₙ of mirror n.

As a result of the feeding through, the line of sight error of mirror n aims to at least partly compensate the summed line of sight errors by mirrors 1 .. m. In more general terms, as a result of the feeding through, the line of image positioning error of optical component n aims to at least partly compensate the summed image positioning errors by optical components 1 .. m.

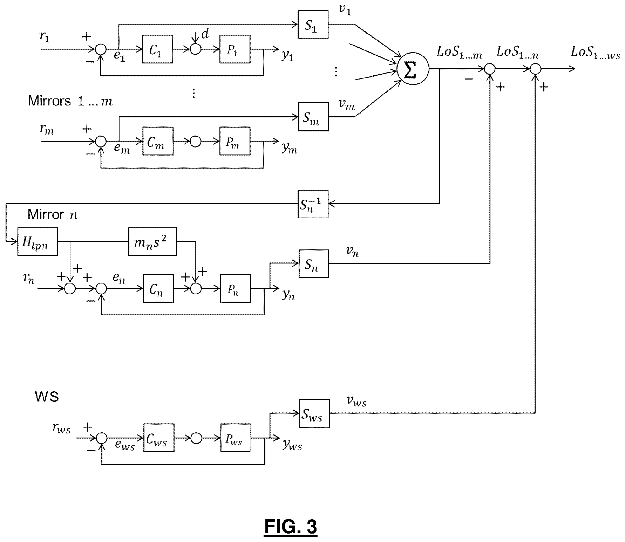

Figure 3 depicts the same controllers of mirrors 1 .. n and further depicts a substrate table control system that controls a position of the substrate table. In the described embodiment, the optical image as projected by the mirror 1 .. n is projected onto a substrate W, the substrate W being held by substrate table Wₜ. The substrate table is positioned by a respective actuator, which is controlled by a respective feedback controller. A setpoint of the position of the substrate table is provided by r_{ws}. Controller C_{ws} is comprised in a feedback control loop which controls a position of plant P_{ws} (the plant comprising the actuator which is configured to actuate the substrate table, the substrate table and a sensor which is configured to measure a position y_{ws} of the substrate table. A sensor signal representative of the position of the substrate table is compared to the position setpoint r_{ws} to generate an error signal e_{ws} which forms the input to the controller C_{ws} of the feedback loop. A substrate table position error, in the present embodiment indicated as the substrate table position error v_{ws} is determined by a multiplication of the error signal e₁, which represents a difference between the substrate table position setpoint and the measured substrate table position, by the optical sensitivity S_{ws} of the substrate table Ws. It is noted that in the figures, the "LoS" signals may represent an impact of the mirror and stage *positions* on substrate level, not an impact of the position *errors.*

Reverting to the calculation of line of sight error of the above described embodiments, in the present example, the summation of reference x sensitivity of the optical components should result in a value of zero to arrive at a net zero Line of Sight error. As a result, the summation of error x sensitivity should likewise result in a value of zero to obtain a net zero Line of Sight error. For this reason, the addition of the substrate table position v_{ws} multiplied by the respective sensitivity and the mirror n position vₙ multiplied by the respective sensitivity to the position errors of the mirrors 1 .. m multiplied by the respective sensitivities may provide a summed line of sight error LoS_{1 .. ws} of the mirrors 1 .. n and the substrate table.

The inventors have sought to further reduce an image positioning error. Thereto, the inventors have sought to further expand the above described feeding through to include the substrate table. More specifically, the inventors have sought to combine the feed through of mirrors 1 .. m to mirror n, with the substrate table, thus to at least partly compensate an image positioning error by the mirrors 1 .. n by the substrate table.

Initially, the inventors have first attempted to feed through the summed line of sight error of mirrors 1 .. n to the substrate table WT. This approach however appeared to be incorrect. As may readily be understood, in case the compensation by mirror n would fully compensate the summed line of sight error from mirrors 1.. m, then the resulting line of sight error, or generally speaking the resulting image position error, would be zero. However, in line with the above described first attempt, the servo errors of the mirrors 1 ..m would also be sent to the substrate table, thereby attempting to compensate what has already been compensated before. Accordingly, the solution to include the substrate table did not provide to be as straightforward as initially devised. Correspondingly, the inventors have devised a means to compensate by a third optical component, a remaining image positioning error when using a first optical component and a second optical component, whereby an image positioning error of the first optical component is fed through to the second optical component to at least partly compensate by the second optical component the image positioning error by the first optical component.

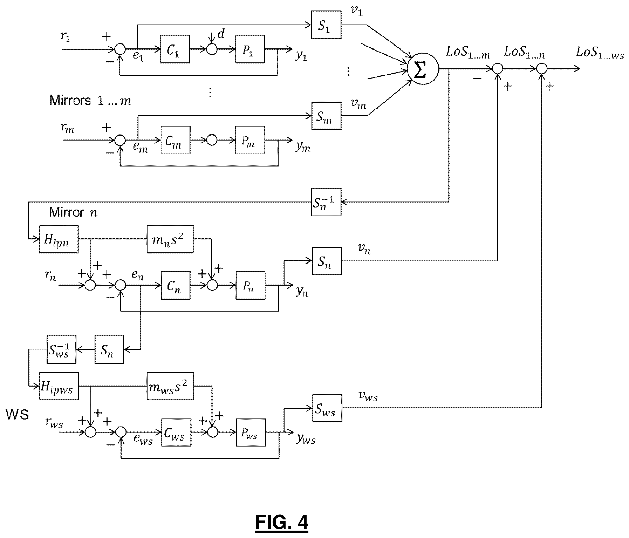

Figure 4 depicts a further embodiment of an optical system, whereby instead of feeding through the line of sight error of all mirrors 1 .. n to the substrate table, only the line of sight error of mirror n is fed through to the substrate table. In more general terms, instead of feeding through the image positioning error of the first component and the image positioning error of the second component to the third component, only the image positioning error of the second component is fed through to the third component.

Figure 4 depicts the control of the mirrors 1 .. m and mirror n as described above with reference to Figures 2 and 3. Furthermore, the line of sight error of the mirror n is fed through to the substrate table . In general terms, the image positioning error of the second component is fed through to the third component.

Specifically, reverting to Figure 4, the error signal eₙ in the feedback control loop of mirror n is multiplied by an optical sensitivity of the mirror n and multiplied by an inverse optical sensitivity S⁻¹_{ws} of the substrate table, the resulting signal being fed through to the substrate table. Similarly to the fed through to the mirror n, a filter is applied for reduction of noise effects, such as in the present example the low pass filter H_{lpws}. The filtered signal is fed through to the substrate table, namely by addition to the setpoint r_{ws} of the substrate table. Moreover, in an embodiment, in order to enhance a dynamic response of the image position error compensation, the Line of Sight error LoSₙ multiplied by an inverse of the optical sensitivity of the substrate table S⁻¹_{ws} is provided as a feedforward signal to the substrate table plant P_{ws}. Thereto, the Line of Sight error LoSₙₘ multiplied by an inverse of the optical sensitivity of the substrate table S⁻¹_{ws} after having been filtered by the filter Hₗₚₘ is twice time-differentiated and multiplied by a mass m_{ws} of the substrate table to generate a feedforward signal which is added to the output signal of the controller C_{ws} of the substrate table.

The multiplications by the optical sensitivity respectively the inverse optical sensitivity may enable to take account of differences in optical sensitivity of the first second and third components.

Although the filter H_{lpws} may promote a suppression of noise and/or other undesired effects, it also appears to affect the compensation in that, for example in the case of a low pass filter, a high frequency content in the error may be suppressed. As another example, dynamic performance may be affected by a delay associated with the filter.

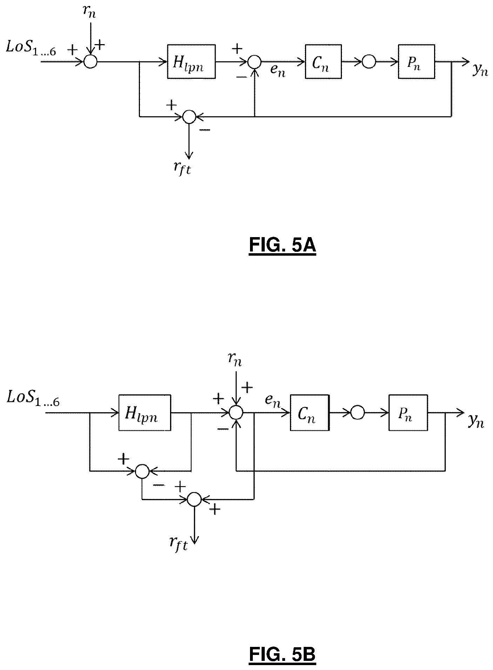

Figures 5 A and 5B depict partial control diagrams illustrating a generation of the feedthrough signal from mirror n to the substrate table, in other words the generation of the feedthrough signal from the second component to the third component.

As depicted in Figure 5A, showing a partial diagram of an embodiment of the generation of the feedthrough signal to the substrate table, the feed through signal r_{ft} is determined from the line of sight error of the mirrors 1 - m, plus the setpoint of mirror n, minus the output of the mirror n (i.e. the actual position of mirror n). In more general terms, the image positioning error of the second component is determined from the image positioning error of the first component plus the setpoint of the second component minus the output of the second component.

As depicted in figure 5B, showing another partial diagram of an embodiment of the generation of the feedthrough signal to the substrate table, the feed through signal r_{ft} is determined from the line of sight error of the mirrors 1 - m, minus the filtered line of sight error of the mirrors 1 - m, plus the servo error of the mirror n. In more general terms, the image positioning error of the second component is determined from the image positioning error of the first component minus a filtered image positioning error of the first component plus the servo error of the second component.

Using the embodiments as described with reference to Figures 5A and 5B, the feed through signal may be determined taking account of the filter, thereby enabling the filter to suppress undesired effects such as noise, however at least partly avoiding a deterioration by the filter on the feedthrough signal.

Although the description to Figures 2 - 5B generally refer to an optical system comprising a first component comprising mirrors 1 .. n, a second component comprising mirror n and a third component comprising a substrate table, the present development may be applied to any suitable combination of optical components. For example, one or more of the components may comprise a mirror or a set of mirrors. One of the components may comprise a substrate table. One of the components may comprise a patterning device that imparts the projection optical beam with a pattern to be projected onto the substrate.

The optical system according to the present development may be comprised in a lithographic apparatus. For example, in a projection system comprising n mirrors, the first component may comprise mirrors 1 - m (m being n-1), the second component may comprise mirror n and the third component may comprise the substrate table or the support of the patterning device. In line with the above description to Figures 2-5, the image positioning error in the first component (in this example mirror 1 - m) may be fed through to the second component (in this example mirror m), and the image positioning error of the second component may be fed through to the third component (in this example the support of the patterning device or the substrate table). Thus, a remaining image positioning error in the first component is at least partly corrected by the second component, and a remaining image positioning error in the second component is at least partly corrected by the third component. An overall image positioning error may be reduced, as the feed through of the image positioning error in the second component to the third component at least compensates the image positioning error in the second component, which may comprise an at least partial compensation of a remainder of the image positioning error in the first component which is not yet compensated by the second component.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Examples

1. A method of controlling an image positioning error in an optical system comprising a first component, a second component and a third component arranged in an optical path of the optical system, the method comprising:
   - determining an image positioning error of the first component and feeding through of the image positioning error of the first component to a control loop of the second component to at least partly compensate the image positioning error of the first component;
   - determining an image positioning error of the second component and feeding through of the image positioning error of the second component to a control loop of the third component to at least partly compensate the image positioning error of the second component.
2. The method according to example 1, wherein the image positioning error of the first component is determined from a servo error of the first component, and
   wherein the image positioning error of the second component is determined from a servo error of the second component.
3. The method according to example 1 or 2, wherein determining the image positioning error of the first component comprises multiplying the servo error of the first component by an optical sensitivity of the first component and wherein determining the image positioning error of the second component comprises multiplying the servo error of the second component by an optical sensitivity of the second component.
4. The method according to any one of the preceding examples, wherein the feeding through of the image positioning error of the first component to the control loop of the second component comprises feeding through the image positioning error of the first component to a setpoint of the second component, and wherein the feeding through of the image positioning error of the second component to the control loop of the third component comprises feeding through the image positioning error of the second component to a setpoint of the third component.
5. The method according to any one of the preceding examples, wherein the image positioning error of the second component is determined from the image positioning error of the first component plus the setpoint of the second component minus the output of the second component.
6. The method according to any one of examples 1 - 4, wherein the image positioning error of the second component is determined from the image positioning error of the first component minus a filtered image positioning error of the first component plus the servo error of the second component.
7. The method according to any one of the preceding examples, wherein the image positioning error of the second component is multiplied by a mass of the third component, twice differentiated and fed to the third component as a feedforward signal.
8. The method according to any one of the preceding examples, wherein the first component comprises at least two mirrors of the projection system and wherein the second component comprises a target mirror of the projection system.
9. The method according to any one of the preceding examples, wherein the third component comprises at least one of a mask table and a substrate table.

## Claims

1. A method of controlling an image positioning error in an optical system comprising a first component, a second component and a third component arranged in an optical path of the optical system, the method comprising:
- determining an image positioning error of the first component and feeding through of the image positioning error of the first component to a control loop of the second component to at least partly compensate the image positioning error of the first component;
- determining an image positioning error of the second component and feeding through of the image positioning error of the second component to a control loop of the third component to at least partly compensate the image positioning error of the second component.

2. The method according to claim 1, wherein the image positioning error of the first component is determined from a servo error of the first component, and
wherein the image positioning error of the second component is determined from a servo error of the second component.

3. The method according to claim 1 or 2, wherein determining the image positioning error of the first component comprises multiplying the servo error of the first component by an optical sensitivity of the first component and wherein determining the image positioning error of the second component comprises multiplying the servo error of the second component by an optical sensitivity of the second component.

4. The method according to any one of the preceding claims, wherein the feeding through of the image positioning error of the first component to the control loop of the second component comprises feeding through the image positioning error of the first component to a setpoint of the second component, and wherein the feeding through of the image positioning error of the second component to the control loop of the third component comprises feeding through the image positioning error of the second component to a setpoint of the third component.

5. An optical system comprising a first component, a second component and a third component arranged in an optical path of the optical system and a controller to control the first component, the second component and the third component, wherein the controller is configured to:
- determine an image positioning error of the first component and feed through of the image positioning error of the first component to a control loop of the second component to at least partly compensate the image positioning error of the first component;
- determine an image positioning error of the second component and feed through of the image positioning error of the second component to a control loop of the third component to at least partly compensate the image positioning error of the second component.

6. The optical system according to claim 5, wherein the controller is configured to determine the image positioning error of the first component from a servo error of the first component, and to determine the image positioning error of the second component from a servo error of the second component.

7. The optical system according to claim 5 or 6, wherein the controller is configured to determine the image positioning error of the first component using multiplication of the servo error of the first component by a sensitivity of the first component and wherein the controller is configured to determine the image positioning error of the second component using multiplication of the servo error of the second component by a sensitivity of the second component.

8. The optical system according to any one of claims 5 - 7, wherein the controller is configured to feed through the image positioning error of the first component to the control loop of the second component using feed through of the image positioning error of the first component to a setpoint of the second component, and wherein the controller is configured to feed through the image positioning error of the second component to the control loop of the third component using feed through the image positioning error of the second component to a setpoint of the third component.

9. The optical system according to any one of claims 5 - 8, wherein the controller is configured to determine the image positioning error of the second component from the image positioning error of the first component plus the setpoint of the second component minus the output of the second component.

10. The optical system according to any one of claims 5 - 8, wherein the controller is configured to determine the image positioning error of the second component from the image positioning error of the first component minus a low pass filtered image positioning error of the first component plus the servo error of the second component.

11. The optical system according to any one of claims 5 - 10, wherein the controller is configured to multiply the image positioning error of the second component by a mass of the third component, twice differentiate and fed to the third component as a feedforward signal.

12. The optical system according to any one of claims 5 - 11, wherein the first component comprises at least two mirrors of the projection system and wherein the second component comprises a target mirror of the projection system.

13. The optical system according to any one of claims 5 - 12, wherein the third component comprises at least one of a mask table and a substrate table.

14. A lithographic apparatus comprising the optical system according to any one of claims 5 - 13.

15. A system comprising a first component, a second component and a third component arranged in an optical path of the optical system and a controller to control the first component, the second component and the third component, wherein the controller is configured to:
- determine an image positioning error of the first component and feed through of the image positioning error of the first component to a control loop of the second component to at least partly compensate the image positioning error of the first component;
- determine an image positioning error of the second component and feed through of the image positioning error of the second component to a control loop of the third component to at least partly compensate the image positioning error of the second component,
wherein the third component comprises at least one of a mask table and a substrate table.
